# EUROPÄISCHE PATENTSCHRIFT

(11) **EP 0 783 707 B1**
(45) Veröffentlichungstag und Bekanntmachung des Hinweises auf die Patenterteilung: **12.08.1998**
(21) Anmeldenummer: 95932619.0
(22) Anmeldetag: 23.09.1995
(51) Int. Cl.: G01R 33/035

(54) **HOCHFREQUENZ-SQUID MIT RESONANTER FLUSSFOKUSSIERUNGSSTRUKTUR**
HIGH-FREQUENCY SQUID WITH A RESONANT FLOW-FOCUSING STRUCTURE
ANNEAU DE COMMUTATION A HAUTE FREQUENCE AVEC STRUCTURE DE FOCALISATION DE FLUX RESONANTE

(30) Priorität: 26.09.1994 DE 4434416; 15.09.1995 DE 19534283
(43) Veröffentlichungstag der Anmeldung: 16.07.1997
(73) Patentinhaber: FORSCHUNGSZENTRUM JÜLICH GMBH, 52425 Jülich (DE)
(72) Erfinder: GOTTSCHLICH, Martin, D-42115 Wuppertal (DE); SODTKE, Erik, D-52223 Stolberg (DE); ZHANG, Yi, D-52428 Jülich (DE)
(86) Internationale Anmeldenummer: DE9501324
(87) Internationale Veröffentlichungsnummer: WO9610190

(56) Entgegenhaltungen:
- WO-A-90/00742
- US-A- 5 420 100
- IEICE TRANSACTIONS ON ELECTRONICS, Bd. E77-C, Nr. 8, 1.August 1994 Seiten 1185-1190, XP 000470609 ITOZAKI H ET AL 'MULTI-CHANNEL HIGH TC SQUID'
- DATABASE INSPEC INSTITUTE OF ELECTRICAL ENGINEERS, STEVENAGE, GB Inspec No. 3832058, BOERSTLER R ET AL 'Non-aqueous one-micron feature size lithography of superconducting films' & SCIENCE AND TECHNOLOGY OF THIN FILM SUPERCONDUCTORS. PROCEEDINGS OF THE CONFERENCE, COLORADO SPRINGS, CO, USA, 14-18 NOV. 1988, ISBN 0-306-43215-3, 1989, NEW YORK, NY, USA, PLENUM, USA, Seiten 469-476,

## Beschreibung

Die Erfindung betrifft einen Hochfrequenz-SQUID (HF-SQUID) mit einer wenigstens einen Josephson-Kontakt enthaltenden SQUID-Schleife und einer Flußfokussierungsstruktur aus supraleitendem Material, die als HF-Resonator wirkt.

HF-SQUID sind hochempfindliche Sensoren für die Messung von magnetischem Fluß. Derartige Sensoren in Dünnschichttechnik sind aus EP 04 18 848 A2 bekannt. Sie bestehen aus einem supraleitenden Ring mit einem inkorporierten Josephson-Kontakt und einem an diesen Ring gekoppelten HF-Resonator (Tankschwingkreis), der mit einem Hochfrequenzstrom geeigneter Amplitude und einer Frequenz typischerweise > 1 GHz gespeist wird. Der supraleitende Ring bedämpft den Resonator in Abhängigkeit vom magnetischen Fluß im Ring, wodurch sich der Spannungsabfall am Resonator und dessen Resonanzfrequenz ändern. Das dabei enstehende Amplituden- oder Phasensignal wird zum Auslesen des Sensors verwendet.

Ein HF-SQUID gemäß dem Oberbegriff des Anspruchs 1 ist auch aus WO-A-9000742 bekannt.

Es ist bekannt, daß das Eigenrauschen und damit der minimal auflösbare magnetische Fluß in der SQUID-Schleife invers proportional zur Betriebsfrequenz des SQUID sind. Weiterhin ist bekannt, daß die magnetflußabhängige Spannungsmodulation am HF-Resonator umso größer wird, je geringer die Kopplungskonstante k zwischen supraleitendem Ring und Resonator ist und umso größer die Güte Q des Resonators ist, wobei die Bedingung k²Q > 1 erfüllt sein muß.

Für den rauscharmen Betrieb des Sensors ist es außerdem notwendig, die Induktivität des supraleitenden Ringes auf Werte kleiner als ca. 300 pH zu begrenzen. Die damit verbundene kleine Fläche des Ringes erschwert die Einkopplung von zu messendem magnetischem Fluß in den Ring.

Zur Verbesserung der Flußfokussierung können zusätzliche supraleitende Flächen in der Nähe des supraleitenden Ringes plaziert werden (Y. Zhang et al., Supercond. Sci. Technol. 7 (1994) 269-272). Bei herkömmlichen HF-SQUID mit Resonatoren in der Form von Streifenleitern ist die Größe der Flußfokussierungsflächen jedoch durch die Ausdehnung des Resonators begrenzt; außerdem wird die Hochfrequenzstromverteilung im Resonator durch die zusätzlichen Flächen in der Nähe des supraleitenden Ringes ungünstig beeinflußt. Aufgrund der geringen Flußfokussierung der herkömmlichen HF-SQUID ist ihre Magnetfeldempfindlichkeit trotz geringen Eigenrauschens geringer als die von konventionellen Wechselstrom-Washer-SQUID, die im Frequenzbereich von wenigen Hundert MHz arbeiten (Y. Zhang et al., IEEE Trans. Appl. Supercond. 3, 2465 (1993)). Bei diesen wird die supraleitende Umrandung der SQUID-Schleife stark verbreitert, um so eine Feldfokussierung in die Schleife zu erreichen.

Die bekannten Washer-SQUID erfordern jedoch einen externen Tankschwingkreis, der im allgemeinen aus diskreten Bauelementen (Spulen und Kondensatoren) aufgebaut ist. Solche Resonatoren sind sowohl in ihrer Güte als auch in ihrer maximalen Resonanzfrequenz beschränkt und können nicht im GHz-Bereich betrieben werden.

Es ist daher Aufgabe der Erfindung, ein HF-SQUID mit Betriebsfrequenzen oberhalb 1 GHz zu schaffen, das den Nachteil geringer Flußfokussierung beseitigt und somit gleichzeitig ein geringes Eigenrauschen und eine hohe Magnetfeldempfindlichkeit besitzt. Der Sensor soll demgemäß bei hoher Frequenz betreibbar sein, eine hohe Güte aufweisen und über eine ausreichende Flußfokussierung verfügen.

Die Aufgabe wird erfindungsgemäß durch einen Sensor mit den Merkmalen des Anspruchs 1 gelöst.

Durch die Integration von HF-Resonator und Flußfokussierungsstruktur in einer gemeinsamen supraleitenden Fläche wird die Größenbegrenzung durch den Streifenleiter der herkömmlichen HF-SQUID aufgehoben. So kann die gesamte zur Verfügung stehende Substratfläche ausgenutzt und eine hohe Feldfokussierung in die SQUID-Schleife erreicht werden. Außerdem kann auf einen externen Resonator als Tankschwingkreis verzichtet werden. Für einen erfindungsgemäßen planaren Resonator in Dünnschichttechnik können in Mikrostreifenkonfiguration Güten von bis zu einigen 1000, in Streifenleitung- oder Koplanarkonfiguration sogar bis zu einigen 10.000 erreicht werden.

Die Ankopplung der HF-Leistung an den Resonator erfolgt im Ein- oder Zweitorbetrieb in bekannter Weise z.B. über kapazitiv gekoppelte HF-Leitungen oder Antennen. Die resonante Flußfokussierungsstruktur ist dazu geometrisch so auszulegen, daß die angeregte HF-Stromverteilung zu einem ausreichenden HF-Strom über den Josephson-Kontakt führt. Die HF-Stromamplitude bestimmt dabei zusammen mit der SQUID-Induktivität die Stärke der Kopplung. Bei gegebener Induktivität steigt die Kopplungskonstante k mit wachsender HF-Stromamplitude.

Frequenz und HF-Stromverteilung der resonanten Modi können durch feldtheoretische Computersimulationen modelliert werden. Auf gängigen Substraten für die Abscheidung von supraleitenden Schichten wie z.B Lanthanaluminat oder Saphir lassen sich für einen ca. 8*8 mm² großen Resonator auf einem 10*10 mm² großen Substrat Resonanzfrequenzen im Bereich 3-5 GHz für die Grundschwingung realisieren. Dadurch ist eine für den rauscharmen Betrieb des Sensors ausreichend hohe Frequenz gewährleistet.

Gemäß Anspruch 2 kann der beschriebene Sensor bei einer Ausführung in hochtemperatursupraleitendem Material vorteilhaft bei Temperaturen im Bereich des flüssigen Stickstoffes eingesetzt werden. Die dem erfindungsgemäßen HF-SQUID anhaftenden Vorteile sind aber auch auf der Basis von Tieftemperatursupraleitern voll nutzbar.

### Ausführungsbeispiel

1. Computersimuliert wurde die HF-Stromverteilung eines konventionellen 8*8 mm² Washer-SQUID mit 200*200 µm² SQUID-Fläche im Grundmodus (Mikrostreifenkonfiguration) bei dem im Gegensatz zum bisher bekannten Betriebsmodus mit externem Tankschwingkreis ein erfindungsgemäßer Betrieb des Washers selbst als HF-Resonator simuliert wurde. Die Resonanzfrequenz der Struktur auf einem 0.5 mm starkem Lanthanaluminatsubstrat liegt bei etwa 3,2 Ghz.

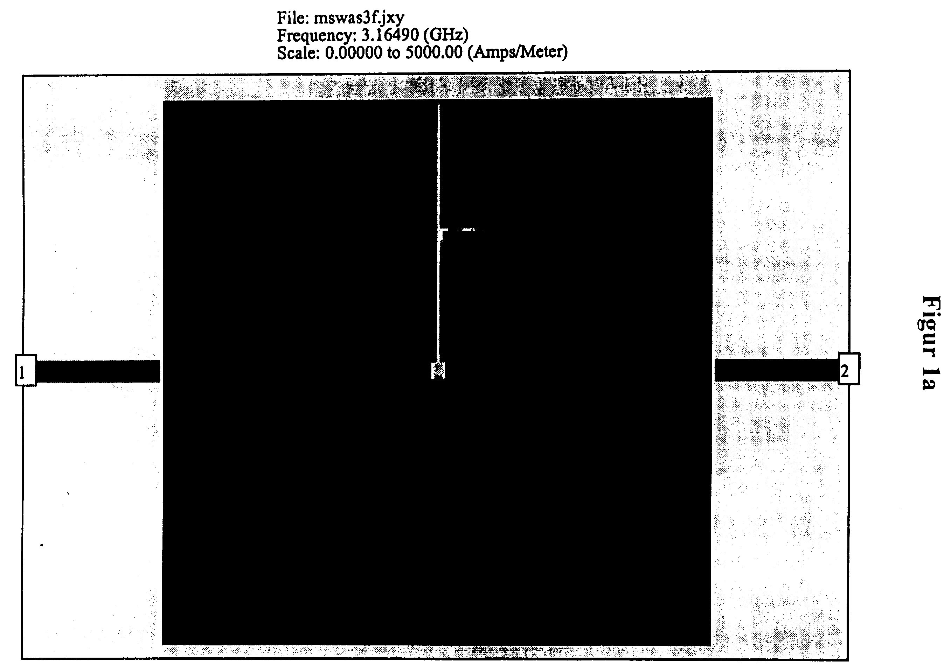

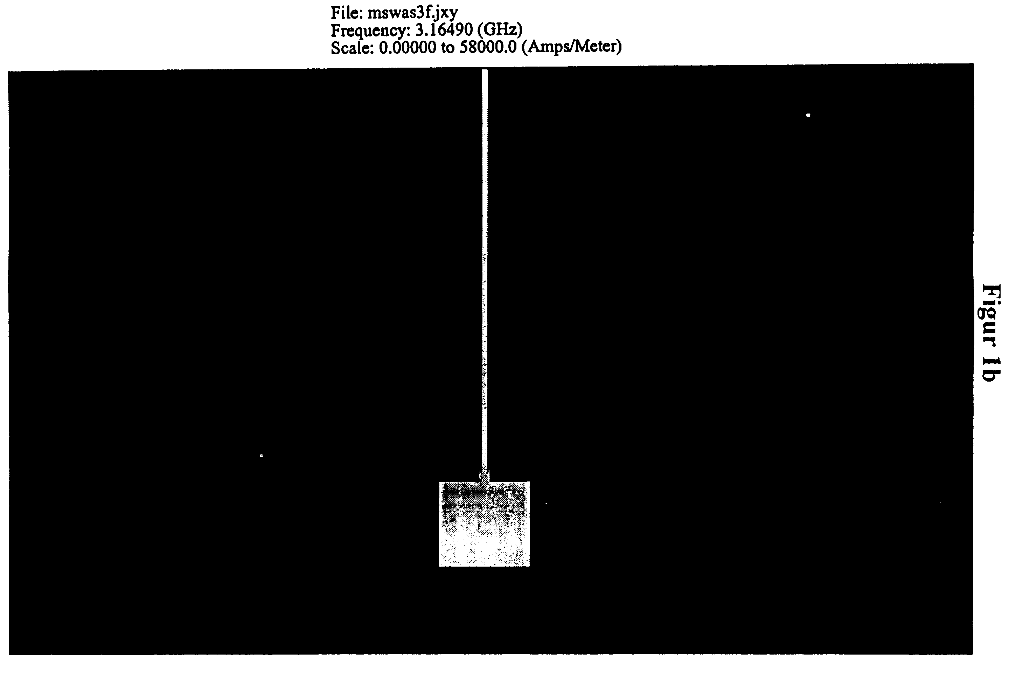

Die Figuren 1a und 1b zeigen die zugehörige HF-Stromverteilung des über Mikrostreifenleitungen kapazitiv an die HF gekoppelten Washer-SQUID. Hohe HF-Stromdichten kommen nur entlang des Washer-Schlitzes und am Rand der SQUID-Schleife vor, mit dem Maximum am Ort des Josephson-Kontaktes.

2. Experimentell konnte dieser resonante Grundmodus für verschiedene Washer-SQUID aus dem Hochtemperatursupraleiter YBCO auf den Substraten Lanthanaluminat (0,5 und 1 mm dick, Resonanzfrequenz 3,25 GHz) und Strontiumtitanat (1 mm dick, Resonanzfrequenz 1,2 GHz) bei einer Temperatur von 77 K identifiziert werden. Bei allen untersuchten Anordnungen zeigten sich bei höheren Frequenzen weitere Resonanzmoden, deren Eignung für den SQUID-Betrieb durch die jeweilige HF-Stomverteilung gegeben ist.

Die Ausprägung aller resonanter Moden konnte durch Variation der Kopplungsgeometrie beeinflußt werden. Die belastete Güte der Washer-SQUID auf Strontiumtitanatsubstraten stieg für Eingangsleistungen zwischen +10 dBm und -40 dBm von 900 auf 1300. Bei geringeren Eingangsleistungen (im Magnetometerbetrieb) werden noch höhere Güten erreicht.

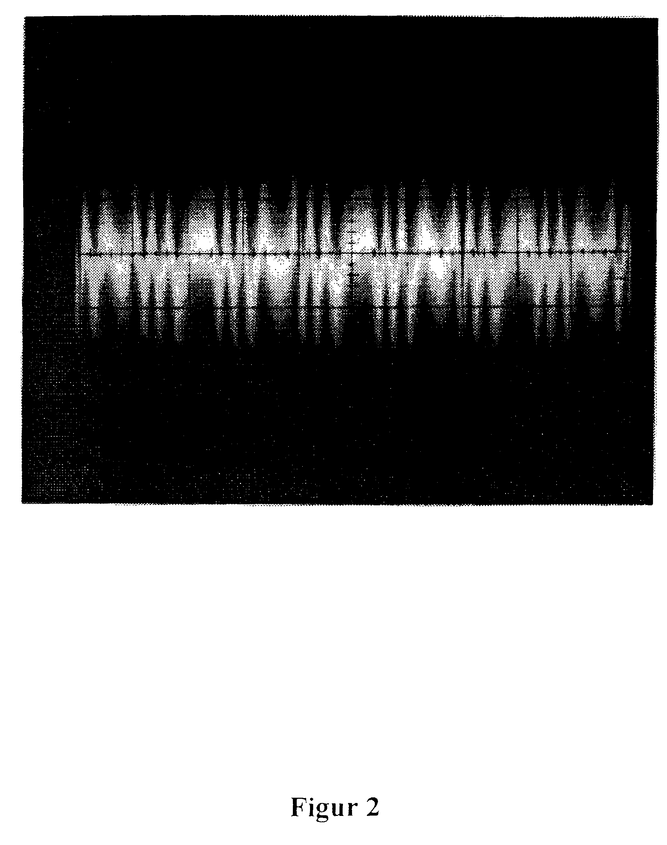

3. Mit einer Ausleseelektronik für Mikrowellen-SQUID (M. Mück, Rev. Sci. Instrum. 63, 2268 (1992)) wurden Washer-SQUID auf 1 mm starken Lanthanaluminatsubstraten mit SQUID-Flächen von 200*200 µm² und 50*50 µm² als Magnetometer betrieben. Die SQUID, die mit einer HF-Ankopplung im Eintorbetrieb in Reflexion ausgelesen wurden, zeigten eine deutliche Modulation der Spannung V als Funktion des Magnetflusses F, wie aus der in Figur 2 gezeigten V(F)-Kennlinie entnehmbar ist.

Im Ergebnis zeigt sich damit, daß bereits herkömmliche RF-Washer-SQUID, wie sie z.B. aus Y. Zhang et al., IEEE Trans. Appl. Supercond. 3, 2465 (1993) bekannt sind, als HF-SQUID mit resonanter flußfokussierender Struktur als Tankschwingkreis im Sinne der Erfindung betrieben werden können.

## Patentansprüche

1. Hochfrequenz-SQUID mit wenigstens einen Josephson-Kontakt enthaltender SQUID-Schleife und einer Flußfokussierungsstruktur aus supraleitendem Material,
**dadurch gekennzeichnet,** daß die Flußfokussierungsstruktur so ausgebildet ist, daß sie gleichzeitig als Tankschwingkreis wirkt, in dem ein oder mehrere resonante Moden zur Ankopplung der Hochfrequenzleistung an die SQUID-Schleife genutzt werden.

2. SQUID nach Anspruch 1, **gekennzeichnet durch** eine Ausführung der flußfokussierenden Struktur in hochtemperatursupraleitendem Material.

## Claims

1. High-frequency SQUID with a SQUID loop containing at least one Josephson contact and with a flow-focusing structure made from supraconducting material,
characterised in that the flow-focusing structure is configured so as to simultaneously act as a tank circuit in which one or more resonant modes are utilised for coupling the high-frequency output to the SQUID loop.

2. SQUID according to claim 1, characterised by the fact that the flow-focusing structure is executed in high-temperature supraconducting material.

## Revendications

1. Anneau de commutation haute fréquence. ayant une boucle d'anneau de commutation qui comporte au moins un contact Josephson et ayant une structure de focalisation de flux en matériau supraconducteur caractérisé en ce que la structure de focalisation de flux est réalisée de telle manière qu'elle agit en même temps comme circuit oscillant de réserve. dans lequel un mode résonant ou plusieurs modes résonants sont utilisés pour appliquer la puissance haute fréquence à la boucle d'anneau de commutation.

2. Anneau de commutation suivant la revendication 1, caractérisé par une réalisation de la structure focalisant le flux en matériau supraconducteur à haute température.
